# EUROPEAN PATENT APPLICATION

(11) **EP 1 583 145 A1**
(43) Date of publication of application: **05.10.2005**
(21) Application number: 03768276.2
(22) Date of filing: 25.12.2003
(51) Int. Cl.: H01L 21/76, H01L 27/12

(54) **METHOD OF PRODUCING SOI WAFER AND SOI WAFER**

(30) Priority: 10.01.2003 JP 2003004833
(71) Applicant: Shin-Etsu Handotai Co., Ltd, Tokyo 100-0005 (JP)
(72) Inventor: AGA, Hiroji c/o Yokonodaira Plant, Nakanoya, Annaka-shi, Gunma 379-0125 (JP); YOKOKAWA, Isao c/o Yokonodaira Plant, Nakanoya, Annaka-shi, Gunma 379-0125 (JP); TAKANO, Kiyotaka c/o Yokonodaira Plant, Nakanoya, Annaka-shi, Gunma 379-0125 (JP); MITANI, Kiyoshi c/o Yokonodaira Plant, Nakanoya, Annaka-shi, Gunma 379-0125 (JP)
(74) Representative: Cooper, John
(86) International application number: PCT/JP2003/016796
(87) International publication number: WO 2004/064145

(57) **Abstract**

The present invention relates to a method of producing an SOI wafer in which an SOI layer is formed on a buried oxide film by forming an oxide film on a surface of at least one of a bond wafer and a base wafer, bonding the bond wafer to the base wafer through the formed oxide film, and making the bond wafer into a thin film, wherein after the oxide film is formed so that a total thickness of the oxide film formed on the surface of at least one of the bond wafer and the base wafer is thicker than a thickness of the buried oxide film that the SOI wafer to be produced has, the bond wafer is bonded to the base wafer through the formed oxide film, the bond wafer is made into a thin film to form an SOI layer, and thereafter, an obtained bonded wafer is subjected to heat treatment to reduce a thickness of the buried oxide film. Thereby, there can be provided a method of producing an SOI wafer in which blisters and voids are not generated even if the thickness of the buried oxide film is thinned, and its SOI layer has extremely good crystallinity.

## Description

### Technical Field

The present invention relates to a method of producing an SOI (Silicon On Insulator) wafer having SOI structure in which a silicon layer is formed on an insulator, and an SOI wafer produced by the method thereof.

### Background Art

Recently, an SOI wafer having SOI structure in which a silicon layer (an SOI layer) is formed on an insulator has been especially attracting attention as a wafer for high-performance LSI for an electronic device because the SOI wafer is excellent in high-speed property, low power consumption, high breakdown voltage, environmental resistance, etc. of the device.

Representative production methods of the SOI wafer are SIMOX method in which an oxide film is formed in a silicon wafer by subjecting to heat treatment at a high temperature after implanting oxygen ions into the silicon wafer at high concentration, a method called a bonding method, etc. The bonding method is a method of producing an SOI wafer in which an SOI layer is formed on a buried oxide film being an insulator by forming the oxide film on at least one of a bond wafer to form the SOI layer and a base wafer to be a supporting substrate, bonding the bond wafer to the base wafer through the oxide film, and making the bond wafer into a thin film.

There are known production methods of the SOI wafer utilizing the bonding method such as a grinding and polishing method, PACE (Plasma Assisted Chemical Etching) method, an ion implantation delamination method (also called "Smart Cut" (registered trademark) method, see Publication of Japanese Patent No. 3048201), ELTRAN method, etc. (see "Science in Silicon", edited by UCS Semiconductor Substrate Technology Workshop, published by Realize publishers, pp. 443-496).

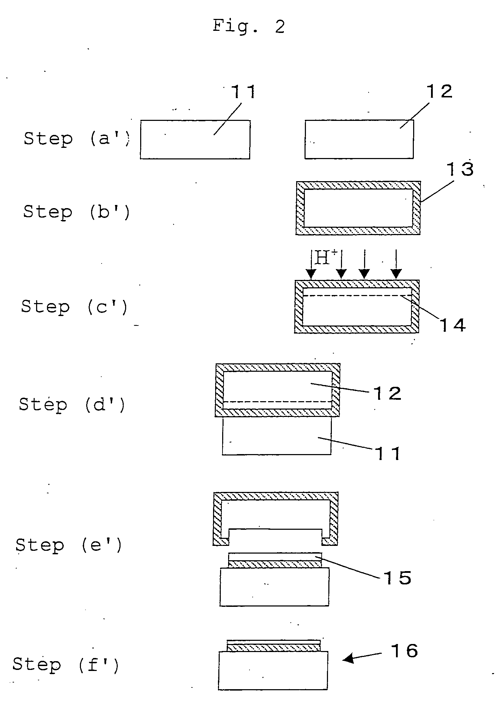

Here, the ion implantation delamination method will be explained with reference to Fig. 2. First, two silicon wafers of a base wafer 11 and a bond wafer 12 are prepared (Step (a')). Next, after forming an oxide film 13 on at least one of these wafers (in this case, the bond wafer) (Step (b')), an ion-implanted layer 14 is formed inside the bond wafer 12 by implanting hydrogen ions or rare gas ions into the bond wafer 12 (Step (c')). Then, after the ion-implanted surface of the bond wafer 12 is bonded to the base wafer 11 through the oxide film 13 (Step (d')), the bond wafer 12 is delaminated at the ion-implanted layer 14 as a cleavage plane (the delaminating plane) by subjecting to delaminating heat treatment to make it into a thin film, so that an SOI layer 15 is formed (Step (e')), thereafter, an SOI wafer 16 can be produced by subjecting to boding heat treatment for further strengthening the bonding between the wafers, a mirror polishing called a touch polishing in which polishing stock removal is very small, etc. (Step (f')).

However, when producing an SOI wafer, if the mirror polishing process including an element of machining has been carried out at the final stage as described above, there occurs a problem that uniformity of the thickness of the SOI layer achieved by the ion implantation/delamination is degraded because the polishing stock removal is not uniform. Moreover, since the mirror polishing is performed after the bonding heat treatment, the method has many steps and is complicated, and also disadvantageous in terms of cost.

In order to solve such a problem, Japanese Patent Application Laid-open Pub. No. 11-307472, for example, discloses technique in which, after an SOI layer has been formed by an ion implantation delamination method and bonding heat treatment has been performed, high-temperature heat treatment is performed in a hydrogen or an Ar atmosphere in order to reduce surface roughness and crystal defects of the SOI layer of an SOI wafer without performing mirror polishing.

Furthermore, with higher integration of semiconductor devices in these years, production of a higher-quality SOI wafer is required and, for example, an SOI wafer having a thinner buried oxide film and an SOI wafer in which crystallinity of its SOI layer is improved are required.

Generally, when an SOI wafer is produced by the ion implantation delamination method as described above, in order to form a buried oxide film having a desired thickness in the SOI wafer, the SOI wafer is produced by forming an oxide film formed on at least one of a bond wafer and a base wafer such that the thickness of the oxide film is the same as a desired thickness of the buried oxide film, and thereafter, bonding these wafers to each other.

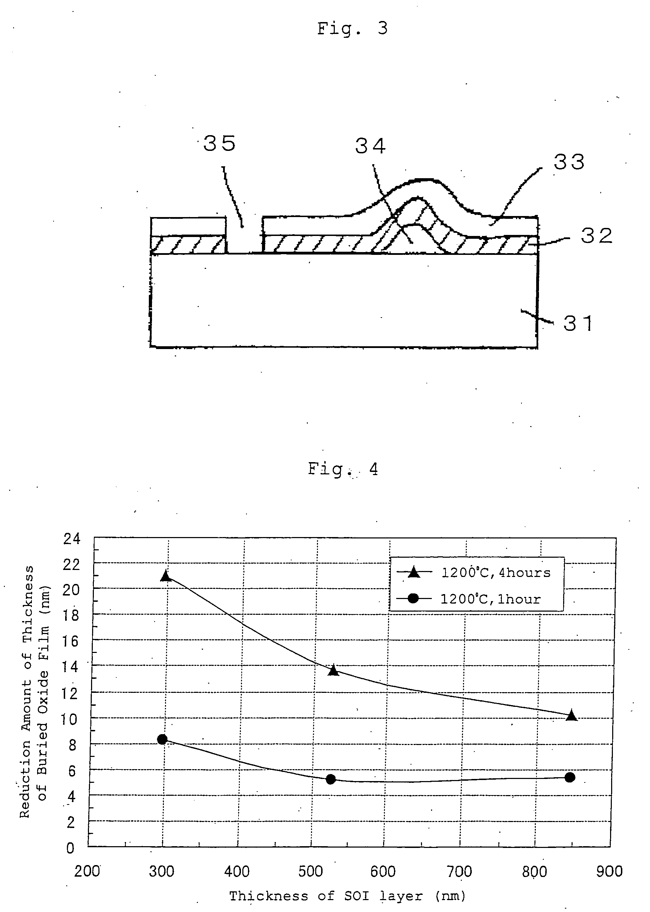

However, in the case of producing an SOI wafer having a buried oxide film with a thickness of, for example, 100 nm or less, when performing delaminating heat treatment after wafers are bonded to each other, as shown in Fig. 3, there has been many cases where blisters 34 and voids 35 are generated in the SOI wafer in which a buried oxide film 32 and an SOI layer 33 are stacked on a base wafer 31, and thereby, unbonded portions are formed. Then, there has been a problem that, as the thickness of the buried oxide film of the SOI wafer becomes thinner, these blisters and voids tend to be generated, and it becomes more difficult to obtain good wafers and the yield becomes worsened.

From now on, the thickness of the buried oxide film formed in the SOI wafer is expected to proceed with such a course as it becomes thinner from 100 nm to 50 nm, etc. Therefore, it has been desired to produce an SOI wafer at a high yield without generating blisters and voids even when the thickness of the buried oxide film is reduced.

Moreover, crystallinity of the SOI layer formed on the SOI wafer by the above bonding method is better than that by the SIMOX method. However, since crystal defects called HF defects and Secco defects generated due to etching are not completely eliminated, further improvement of the crystallinity has been desired.

### Disclosure of the Invention

Accordingly, the present invention was conceived in view of the above problems. The object of the present invention is to provide a method of producing an SOI wafer in which blisters and voids are not generated even when the thickness of a buried oxide film is reduced, and its SOI layer has extremely good crystallinity.

In order to accomplish the above object, according to the present invention, there is provided a method of producing an SOI wafer in which an SOI layer is formed on a buried oxide film by forming an oxide film on a surface of at least one of a bond wafer and a base wafer, bonding the bond wafer to the base wafer through the formed oxide film, and making the bond wafer into a thin film, wherein after the oxide film is formed so that a total thickness of the oxide film formed on the surface of at least one of the bond wafer and the base wafer is thicker than a thickness of the buried oxide film that the SOI wafer to be produced has, the bond wafer is bonded to the base wafer through the formed oxide film, the bond wafer is made into a thin film to form an SOI layer, and thereafter, an obtained bonded wafer is subjected to heat treatment to reduce a thickness of the buried oxide film.

As described above, after the oxide film is formed beforehand so that the buried oxide film having a thickness thicker than a desired thickness can be obtained, these wafers are bonded to each other and the bond wafer is made into a thin film to form an SOI layer, and thereafter, a thickness of the buried oxide film is adjusted to a desired thickness by subjecting a bonded wafer to heat treatment to reduce the thickness of the buried oxide film. Therefore, an SOI wafer having a desired thin buried oxide film can be produced at a high yield without generating blisters and voids. Also, since the thickness of the buried oxide film is reduced by the heat treatment, the portion where the thickness is decreased is deoxidized to be a silicon layer having good crystallinity. Moreover, since the SOI layer is grown by solid-phase growth during the heat treatment from the silicon layer having good crystallinity as a seed, an SOI layer having extremely good crystallinity can be obtained.

In this case, it is preferable that a thickness of the SOI layer formed by making the bond wafer into a thin film is 500 nm or less.

When the SOI layer is thicker than 500 nm, even if subsequent heat treatment to reduce the thickness of the buried oxide film is performed, since the reduction amount of the thickness of the buried oxide film is small, the heat treatment must be performed for a long time so as to obtain the buried oxide film having a desired thickness. However, if a thickness of the SOI layer is 500 nm or less by making the bond wafer into a thin film etc. as described above, the heat treatment to reduce the thickness of the buried oxide film can be performed efficiently, and thus, the thickness of the buried oxide film can be reduced to a desired thickness in a short period.

Also, it is preferable that the heat treatment to reduce the thickness of the buried oxide film is performed in an atmosphere of a hydrogen gas, an argon gas, or a mixed gas of those at a temperature of 1000 °C or more.

By performing the heat treatment to reduce the thickness of the buried oxide film under such conditions, the thickness of the oxide film can be reduced efficiently, and the buried oxide film having a desired thin thickness can be surely obtained.

And, according to the present invention, a thickness of the buried oxide film can be reduced to 100 nm or less by the heat treatment to reduce the thickness of the buried oxide film.

As described above, by performing the heat treatment to reduce the thickness of the buried oxide film, generation of blisters and voids can be surely prevented, and an SOI wafer in which the buried oxide film having a thickness of 100 nm or less is formed can be easily produced.

Moreover, it is preferable that before the bond wafer is bonded to the base wafer, hydrogen ions or rare gas ions are implanted into a surface layer portion of the bond wafer to form an ion-implanted layer, and after an ion-implanted surface of the bond wafer is bonded to the base wafer, the bond wafer is delaminated at the formed ion-implanted layer to make the bond wafer into a thin film.

The present invention is very effective when the bond wafer is made into a thin film by the ion implantation delamination method. The bond wafer is made into a thin film by the ion implantation delamination method as described above, and thereby, an SOI wafer of which SOI layer has high thickness uniformity can be obtained.

And, it is preferable that after the heat treatment to reduce the thickness of the buried oxide film is performed, sacrificial oxidation treatment is further performed.

As described above, after the heat treatment to reduce the thickness of the buried oxide film is performed, so-called sacrificial oxidation treatment in which a thermal oxide film is formed on an SOI layer and the oxide film is eliminated is further performed, and thereby, a damage layer generated on a surface of the SOI wafer due to the ion implantation can be eliminated, and the thickness of the SOI layer can be adjusted while further increasing crystal quality of the SOI layer.

And, according to the present invention, there can be provided an SOI wafer produced by the above method of producing an SOI wafer of the present invention.

If an SOI wafer is produced by the above method of producing an SOI wafer of the present invention, there can be provided an SOI wafer without generating blisters and voids even when the thickness of its buried oxide film is thin, and its SOI layer has extremely good crystallinity.

As explained above, according to the present invention, there can be produced an SOI wafer at a high yield without generating blisters and voids even when the thickness of its buried oxide film is thinned to have a desired thickness, and its SOI layer has extremely good crystallinity.

### Brief Explanation of the Drawings

Fig. 1 is a flowchart illustrating an example of a method of producing an SOI wafer by an ion implantation delamination method according to the present invention.

Fig. 2 is a flowchart illustrating a conventional method of producing an SOI wafer by an ion implantation delamination method.

Fig. 3 is a schematic explanatory diagram illustrating schematically a void and a blister generated in an SOI wafer.

Fig. 4 is a graph illustrating the relation between heat treatment time of the heat treatment to reduce the thickness of buried oxide film and the reduction amount of the thickness of buried oxide film, and the relation between the thickness of SOI layer formed in a bonded wafer and the reduction amount of the thickness of buried oxide film.

### Best Mode for Carrying out the Invention

Hereinafter, embodiments of the present invention will now be described. However, the present invention is not limited thereto.

Conventionally, when the production of an SOI wafer having a buried oxide film with the thickness of 100 nm or less is attempted using an ion implantation delamination method, blisters and voids tend to be generated in delaminating heat treatment after bonding wafers, and there have been problems that as the thickness of the buried oxide film becomes thinner, the production yield is decreased.

As to the generation of these blisters and voids, it has been considered that degassing occurs during the delaminating heat treatment at the bonding interface due to organic material etc. adhering to bonding planes, and the gas generated during the delaminating heat treatment can be taken in the buried oxide film when the buried oxide film is thick in some degree, however, all of the gas generated during the delaminating heat treatment can not be taken in when the buried oxide film is thin because the volume of the gas capable of being taken in is reduced, and then, blisters and voids are generated due to the remaining gas.

Then, the inventors of the present invention have assiduously studied and discussed a method of producing an SOI wafer in which blisters and voids are not generated, the thickness of the buried oxide film is thin, and the SOI layer has good crystallinity. As a result, they found that when producing an SOI wafer by a bonding method, after an oxide film is formed so that the total thickness of the oxide film formed on at least one wafer surface of two wafers is thicker than the thickness of the buried oxide film that the SOI wafer to be produced has, the wafers are bonded to each other and the bond wafer is made into a thin film to form an SOI layer, thereafter, an obtained bonded wafer is subjected to heat treatment, and thereby, the thickness of the buried oxide film can be reduced to a desired thickness of 100 nm or less without generating blisters and voids, and moreover, the SOI layer has good crystallinity. Finally the present invention was completed.

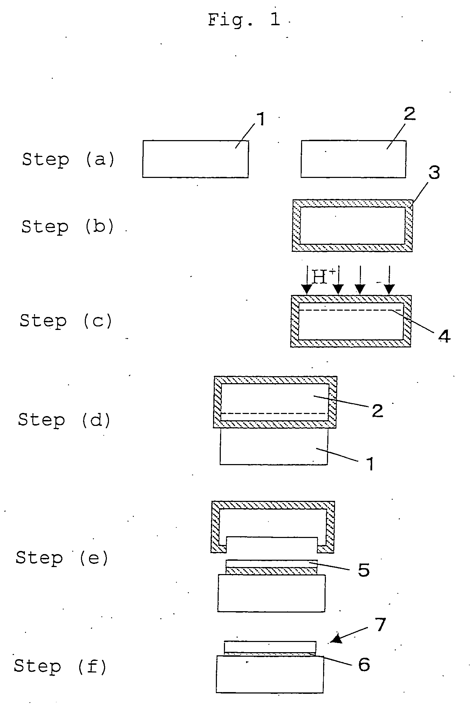

Hereinafter, the method of producing an SOI wafer of the present invention will be explained in detail by illustrating the case where two silicon wafers are bonded to each other with reference to the drawings. However, the present invention is not limited thereto. Here, Fig. 1 is a flowchart illustrating an example of a method of producing an SOI wafer by an ion implantation delamination method according to the present invention.

First, two mirror-polished silicon wafers are prepared (Step (a)). Of these two silicon wafers, one wafer is a base wafer 1 to be a supporting substrate suiting to the specification of a device and the other wafer is a bond wafer 2 to be an SOI layer.

Next, in Step (b), at least one of the wafers, the bond wafer 2 in this case, is subjected to thermal oxidation treatment to form an oxide film 3 on the surface thereof. In this case, the oxide film is formed so that the thickness of the oxide film formed on the surface of the bond wafer is thicker than the thickness of a buried oxide film that the SOI wafer should finally have when the SOI wafer has been produced, for example, the oxide film is formed so as to have a thickness of 100 nm or more. As described above, since the oxide film is formed so as to have a thickness of 100 nm or more, generation of blisters and voids can be surely prevented in subsequent delaminating heat treatment.

In this Step (b), a wafer on which the oxide film may be formed is not limited to the bond wafer, and the oxide film may be formed on the base wafer or both of the base wafer and the bond wafer respectively. For example, in the case where oxide films are formed on both of the base wafer and the bond wafer respectively, the oxide films are formed so that a total thickness of the oxide films formed on the surfaces of both wafers is thicker than a desired thickness of the buried oxide film that the SOI wafer should finally have.

Next, in Step (c), an ion-implanted layer 4 parallel to a wafer surface at an average penetration depth of ion is formed by implanting hydrogen ions (H⁺ ions, H⁻ ions, H₂⁺ ions, etc.) into a surface portion of the bond wafer 2 in which the oxide film 3 is formed on its surface. In this case, as to the ions to be implanted into the bond wafer 2, rare gas ions or mixture of hydrogen ions and rare gas ions may be possible.

After the ion-implanted layer 4 is formed in the bond wafer 2, in Step (d), the hydrogen ion-implanted surface of the bond wafer 2 is superposed on the base wafer 1 through the oxide film 3 and brought into close contact with it. In this case, the wafers can be bonded to each other without using adhesive etc. by, for example, contacting the surfaces of the two wafers to each other in a clean atmosphere at the room temperature.

Then, after bonding the wafers to each other, in Step (e), the bond wafer is made into a thin film to form an SOI layer 5. Making the bond wafer 2 into a thin film can be easily performed by, for example, subjecting it to delaminating heat treatment in an inert gas atmosphere at a temperature of about 500°C or more to delaminate it at the ion-implanted layer 4 formed in the bond wafer 2 by the above hydrogen ion implantation as an interface. In this case, since the buried oxide film is thickly formed beforehand in the present invention, generation of voids and blisters due to degassing can be suppressed. Additionally, the delaminating heat treatment may be omitted by subjecting the surface of the wafer before bonding to plasma treatment to make it activated, and bonding the wafers to each other.

By making the bond wafer into a thin film by the ion implantation delamination method as described above, the SOI layer having extremely good thickness uniformity can be easily formed. Also, an SOI layer having a desired thickness can be precisely formed by a touch polishing after the bond wafer is delaminated at the ion-implanted layer.

After that, by subjecting the obtained bonded wafer to the heat treatment to reduce a thickness of the buried oxide film in Step (f), the SOI wafer 7 having a buried oxide film 6 of which thickness is reduced to a desired thickness can be produced. The thickness of the buried oxide film of the SOI wafer finally obtained depends on the product standards, however, according to the present invention, the thickness is possible to be 100 nm or less, further 50 nm or less.

It may be possible that the bonded wafer after delamination is subjected directly to the heat treatment in Step (f) while omitting the touch polishing, or the touch polishing is performed after the heat treatment in Step (f).

Conditions of the heat treatment to reduce the thickness of the buried oxide film can be determined according to demands, and they are not limited in particular. For example, the heat treatment is performed in an atmosphere of a hydrogen gas, an argon gas, or a mixed gas of those at a temperature of 1000 °C or more, preferably 1100 °C or more, more preferably 1150 °C or more. By performing the heat treatment to reduce the thickness of the oxide film under such conditions, the thickness of the buried oxide film can be effectively reduced, so that there can be easily obtained the buried oxide film having a thickness of less than 100 nm, for example, 10 - 80 nm, and there can be produced an SOI wafer in which the bonding strength between the wafers are increased, so that they are bonded strongly to each other.

Here, there will be shown experimental results concerning the relation between heat treatment time of the heat treatment to reduce the thickness of the buried oxide film and the reduction amount of the thickness of the buried oxide film, and the relation between the thickness of the SOI layer formed in a bonded wafer and the reduction amount of the thickness of the buried oxide film.

First, in order to investigate the relation between the heat treatment time and the reduction amount of the thickness of the buried oxide film, there were prepared three kinds of two bonded wafers in which SOI layers having thickness of 297, 525, and 846 nm respectively were formed on the buried oxide films with 80 nm in thickness. Each bonded wafer was subjected to heat treatment to reduce the thickness of each buried oxide film in 100% argon gas atmosphere at 1200 °C for 1 hour or 4 hours. Thereafter, reduction amount of the thickness of each buried oxide film under each heat treatment condition was measured. The reduction amount of the thickness of each buried oxide film was measured by measuring the thickness of the buried oxide films of each bond wafer before and after the heat treatment with a multi-layer spectroscopic ellipsometer (manufactured by SOPRA).

As a result, as shown in Fig. 4, it was found that as the heat treatment time became longer, the reduction amount of the thickness of the buried oxide film became larger. Although not shown in Fig. 4, in the case of the same heat treatment time, as the heat treatment temperature became higher, the reduction amount of the thickness of the buried oxide film became larger, and when the heat treatment temperature was less than 1000 °C, the reduction amount of the thickness of the buried oxide film became even smaller.

Further, as clear from Fig. 4, by reducing the thickness of the SOI layer to be formed on the buried oxide film from 846 to 297 nm, the reduction amount of the thickness of the buried oxide film in the heat treatment can be increased. It was revealed that when the thickness of the SOI layer formed on the buried oxide film is thicker than 500 nm, even if the heat treatment to reduce the thickness of the oxide film is performed, it is necessary to perform the heat treatment for a long time so as to obtain a buried oxide film having a desired thickness since the reduction amount of the thickness of the buried oxide film is small. Therefore, it is preferable that the thickness of the SOI layer formed by thinning the bond wafer is 500 nm or less, and thereby, the heat treatment to reduce the thickness of the buried oxide film can be effectively performed, and the buried oxide film can be thinned to a desired thickness in a short period.

Furthermore, in the method of producing an SOI wafer of the present invention, it is preferable that after the heat treatment to reduce the thickness of the buried oxide film is performed, a thermal oxide film is formed on the SOI layer, and the oxide film is eliminated, i.e., sacrificial oxidation treatment is performed.

For example, after the heat treatment to reduce the thickness of the buried oxide film is performed, heat treatment is performed in an oxidation atmosphere to form an oxide film on a surface of an SOI layer, and thereafter, the oxide film formed on the SOI layer surface is eliminated. In this case, the oxide film may be eliminated by etching with an aqueous solution containing HF, for example. If the oxide film is eliminated by etching with an aqueous solution containing HF, only the oxide film is eliminated by the etching, and thus, there can be obtained an SOI wafer in which damages and contaminants such as heavy metals are eliminated by means of sacrificial oxidation.

As described above, after the heat treatment to reduce the thickness of the buried oxide film is performed, sacrificial oxidation treatment is further performed. Thereby, a damaged layer generated on a surface of the SOI layer due to ion implantation can be surely eliminated, and moreover, since the thickness of the SOI layer can be adjusted while further increasing the crystal quality of the SOI layer, a higher-quality SOI wafer can be produced.

The SOI wafer is produced by the method as described above, and thereby, an SOI wafer in which generation of blisters and voids is suppressed and its buried oxide film is thinned to a desired thickness can be produced at a high yield. Also, since the thickness of the buried oxide film is reduced by the heat treatment to reduce the thickness of the buried oxide film, the portion where the thickness is decreased is deoxidized to be a silicon layer having good crystallinity, and since an SOI layer is grown by solid-phase growth from the silicon layer having good crystallinity as a seed, an SOI layer having extremely good crystallinity can be obtained.

Hereinafter, the present invention will be explained further in detail with reference to Examples and Comparative Example. However, the present invention is not limited thereto.

### (Example 1)

Mirror-polished silicon wafers having a diameter of 200 mm were prepared to produce an SOI wafer having a buried oxide film with a thickness of 80 nm as a product standard by an ion implantation delamination method.

First, after a silicon wafer to be a bond wafer was thermally oxidized to form an oxide film having a thickness of 100 nm on a surface of the silicon wafer, hydrogen ions were implanted into the silicon wafer at implantation energy of 53 keV (Implantation dose: 5.5 x 10¹⁶/cm²) to form an ion-implanted layer. Then, after the bond wafer was bonded to a base wafer through the oxide film, delaminating heat treatment was performed in a nitrogen atmosphere at 500 °C for 30 minutes to delaminate the bond wafer at the ion-implanted layer, a wafer having an SOI layer was produced. The obtained bonded wafer was subjected to a touch polishing with a stock removal of 60 nm to form the SOI layer having a thickness of 320 nm.

After that, the bonded wafer was subjected to heat treatment to reduce the thickness of the buried oxide film in an argon gas atmosphere at 1200 °C for 4 hours to reduce the thickness of the buried oxide film by 20 nm, and an SOI wafer having the buried oxide film of 80 nm was produced.

### (Example 2)

Mirror-polished silicon wafers having a diameter of 200 mm were prepared to produce an SOI wafer having a buried oxide film with a thickness of 30 nm as a product standard by an ion implantation delamination method.

First, after a bond wafer was thermally oxidized to form an oxide film having a thickness of 80 nm on a surface of the silicon wafer, hydrogen ions were implanted into the silicon wafer at implantation energy of 50 keV (Implantation dose: 5.5 x 10¹⁶/cm²) to form an ion-implanted layer. Then, after the bond wafer was bonded to a base wafer having an oxide film with a thickness of 20 nm on its surface through the oxide film, delaminating heat treatment was performed in a nitrogen atmosphere at 500 °C for 30 minutes to delaminate the bond wafer at the ion-implanted layer, a wafer having an SOI layer was produced. The obtained bonded wafer was subjected to a touch polishing with a stock removal of 60 nm to form the SOI layer having a thickness of 320 nm.

After that, the bonded wafer was subjected to heat treatment to reduce the thickness of the buried oxide film in an argon gas atmosphere at 1200 °C for 14 hours to reduce the thickness of the buried oxide film by 70 nm, and an SOI wafer having the buried oxide film of 30 nm was produced.

### (Comparative Examples 1 and 2)

Two pairs of two mirror-polished silicon wafers having a diameter of 200 mm were prepared to produce SOI wafers having buried oxide films with a thickness of 80 nm (Comparative Example 1) and with a thickness of 30 nm (Comparative Example 2) respectively as a product standard by an ion implantation method.

First, after bond wafers were thermally oxidized, and oxide films having a thickness of 80 nm (Comparative Example 1) and a thickness of 30 nm (Comparative Example 2) respectively were formed on the wafer surface, hydrogen ions were implanted into the wafer of Comparative Example 1 at implantation energy of 50 keV and implanted into the wafer of Comparative Example 2 at implantation energy of 44 keV (Implantation dose: 5.5 x 10¹⁶/cm²) to form each ion-implanted layer. Then, after each bond wafer was bonded to each base wafer having no oxide film on the surface through the oxide film, delaminating heat treatment was performed in a nitrogen atmosphere at 500 °C for 30 minutes to delaminate each bond wafer at the ion-implanted layer, and wafers having an SOI layers were produced. Each obtained bonded wafer was subjected to a touch polishing with a stock removal of 60 nm to form an SOI layer having a thickness of 320 nm.

The SOI wafers produced in Examples 1 and 2 and Comparative Examples 1 and 2 were subjected to visual inspection under a fluorescent light to measure the existence of generation of voids and blisters. These results of measurements are shown in Table 1 with production conditions of the above SOI wafers as follows.

**(Table 1)**

| | Example 1 | Example 2 | Comparative Example 1 | Comparative Example 2 |
|---|---|---|---|---|
| Thickness of formed oxide film in total | 100 nm | 100 nm | 80 nm | 30 nm |
| Implantation energy | 53 keV | 50 keV | 50 keV | 44 keV |
| Implantation dose (/cm²) | 5.5x10¹⁶ | 5.5x10¹⁶ | 5.5x10¹⁶ | 5.5x10¹⁶ |
| Stock removal of touch polishing | 60 nm | 60 nm | 60 nm | 60 nm |
| Thickness of SOI layer | 320 nm | 320 nm | 320 nm | 320 nm |
| Heat treatment conditions to reduce thickness of oxide film | In Ar gas atmosphere at 1200°C for 4 or 14 hours | | Non | Non |
| Thickness of buried oxide film after heat treatment | 80 nm | 30 nm | - | - |
| Amount of generation of voids and blisters | 0 | 2 | 19 | 26 |

As shown in Table 1, neither void nor blister is generated in the SOI wafer of Example 1. In the SOI wafer of Example 2, even though its buried oxide film is 30 nm, i.e., thin, only generation of a few voids and blisters was observed. On the other hand, in the SOI wafers of Comparative Examples 1 and 2, as compared with the SOI wafers of Examples 1 and 2, which had the same thickness of the buried oxide films, respectively, remarkable generation of voids and blisters was observed. Therefore, they were inferior in quality.

The present invention is not limited to the embodiments described above. The above-described embodiments are mere examples, and those having substantially the same structure as that described in the appended claims and providing the similar functions and advantages are included in the scope of the present invention.

For example, in the above method of producing an SOI wafer of the present invention, bonding heat treatment to further increase the bonding strength between the bond wafer and the base wafer can be performed, and thereby, there can be obtained an SOI wafer in which the wafers are further firmly bonded to each other.

Moreover, in the above embodiments, the bond wafer is thinned by the ion implantation delamination method. However, the present invention is not limited thereto, and, for example, a grinding and polishing method or PACE method can be applied to the present invention.

## Claims

1. A method of producing an SOI wafer in which an SOI layer is formed on a buried oxide film by forming an oxide film on a surface of at least one of a bond wafer and a base wafer, bonding the bond wafer to the base wafer through the formed oxide film, and making the bond wafer into a thin film, wherein after the oxide film is formed so that a total thickness of the oxide film formed on the surface of at least one of the bond wafer and the base wafer is thicker than a thickness of the buried oxide film that the SOI wafer to be produced has, the bond wafer is bonded to the base wafer through the formed oxide film, the bond wafer is made into a thin film to form an SOI layer, and thereafter, an obtained bonded wafer is subjected to heat treatment to reduce a thickness of the buried oxide film.

2. The method of producing an SOI wafer according to Claim 1, wherein a thickness of the SOI layer formed by making the bond wafer into a thin film is 500 nm or less.

3. The method of producing an SOI wafer according to Claim 1 or Claim 2, wherein the heat treatment to reduce the thickness of the buried oxide film is performed in an atmosphere of a hydrogen gas, an argon gas, or a mixed gas of those at a temperature of 1000 °C or more.

4. The method of producing an SOI wafer according to any one of Claims 1-3, wherein the thickness of the buried oxide film is reduced to 100 nm or less by the heat treatment to reduce the thickness of the buried oxide film.

5. The method of producing an SOI wafer according to any one of Claims 1-4, wherein before the bond wafer is bonded to the base wafer, hydrogen ions or rare gas ions are implanted into a surface layer portion of the bond wafer to form an ion-implanted layer, and after the ion-implanted surface of the bond wafer is bonded to the base wafer, the bond wafer is delaminated at the formed ion-implanted layer to make the bond wafer into a thin film.

6. The method of producing an SOI wafer according to any one of Claims 1-5, wherein after the heat treatment to reduce the thickness of the buried oxide film is performed, sacrificial oxidation treatment is further performed.

7. An SOI wafer produced by the method of producing an SOI wafer according to any one of Claims 1-6.
